Europäisches Patentamt

European Patent Office

Office européen des brevets

(11) Publication number: **0 220 020 B1**

## EUROPEAN PATENT SPECIFICATION

(45) Date of publication of patent specification: **08.07.92**

(21) Application number: **86307758.2**

(22) Date of filing: **08.10.86**

(51) Int. Cl.⁵: **G11C 11/56**, H03K 3/29, H03K 3/36

(54) **Multiple-value logic circuitry.**

(30) Priority: **09.10.85 JP 223690/85**

(43) Date of publication of application:
**29.04.87 Bulletin 87/18**

(45) Publication of the grant of the patent:
**08.07.92 Bulletin 92/28**

(84) Designated Contracting States:
**DE FR GB**

(56) References cited:
**US-A- 3 155 845**
**US-A- 3 660 678**

(73) Proprietor: **FUJITSU LIMITED**
**1015, Kamikodanaka Nakahara-ku**
**Kawasaki-shi Kanagawa 211(JP)**

(72) Inventor: **Yokoyama, Naoki**
**River Haitsu 326 2557-1, Tsumada**
**Atsugi-shi Kanagawa 243(JP)**
Inventor: **Taguchi, Masao**
**4-3-4-201, Araisono**
**Sagamihara-shi Kanagawa 228(JP)**

(74) Representative: **Fane, Christopher Robin King**
**et al**
**HASELTINE LAKE & CO. Hazlitt House 28**
**Southampton Buildings Chancery Lane**
**London, WC2A 1AT(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

**Description**

The present invention relates to logic circuitry.

Binary logic circuits have been used extensively for a long time. Theoretically, however, the performance of a ternary (tristable) logic circuit could be superior to that of a binary logic circuit, and therefore attempts have been made to realize ternary logic circuits. However, ternary logic circuits were hitherto characterised by complex circuitry and small voltage/current differences between the three logic states, which resulted in those circuits being difficult to use in practice.

Advances in semiconductor processing technology, such as molecular beam epitaxy (MBE) and metal organic chemical vapour deposition (MOCVD), have enabled practical resonant-tunnelling transistors such as resonant-tunnelling hot electron transistors (RHET), to be developed (e.g., "RESONANT-TUNNELLING HOT ELECTRON TRANSISTORS (RHET): POTENTIAL AND APPLICATIONS", N. Yokoyama, et al, Japanese Journal of Applied Physics, Vol. 24, No. 11, November, 1985, pp. L853 - L854). As indicated in that document, however, logic circuitry employing known practical resonant-tunnelling transistors can provide only a total of two discrete output values in response to three discrete input signals, and hence cannot be used to form ternary logic circuits. This is because the collector-emitter current flowing in such known transistors upon application thereto of a "low" voltage is barely distinguishable from that flowing upon application of a "high" voltage.

In contrast, the applicants herein propose a logic gate employing an advantageous resonant-tunnelling transistor which can provide three discrete output values in response respectively to three discrete input signals, this being achieved by forming the superlattice structure of the transistor in such a way that the potential barrier heights thereof differ from one another sufficiently to ensure that the value of the current flowing between the collector and the emitter of the transistor when the input signal voltage is "high" differs considerably from that flowing when the input signal voltage is "low".

According to a first aspect of the present invention, there is provided a logic gate comprising: a resonant-tunnelling transistor having a base, an emitter and a collector, there being between the base and the emitter a superlattice structure providing a quantum well layer between first and second barrier layers, said quantum well layer having a resonant-state energy level; and a resistor connected in series, between first and second power supply lines, with the emitter-collector current path of said resonant-tunnelling transistor; the base of said resonant-tunnelling transistor serving as an input terminal of the logic gate for the application thereto of an input voltage signal constituting a base-to-emitter voltage of the said transistor when the gate is in use; and a circuit node between the said resistor and the transistor serving as an output terminal of the logic gate for delivering an output voltage signal when the gate is in use; whereby when the input voltage signal is increased, from a first working voltage value to a second working voltage value, current passing along the said emitter-collector current path is thereby caused to increase from a first current value to a second current value, and when the input voltage signal is increased from the second working voltage value to a third working voltage value such current is thereby caused to decrease from said second current value to a third current value; the said superlattice structure being so formed that when the said input voltage signal has the said third working voltage value the potential height of one of said first and second barrier layers differs from that of the other sufficiently to ensure that said third current value lies between and is distinct from the said first and second current values, so that the said output voltage signal has discrete first, second and third output values respectively when the said input voltage signal has the said first, second and third working voltage values, the said third output value of the output voltage signal being between the said first and second output values thereof.

The resonant-tunnelling transistor of such a logic gate may be a resonant-tunnelling hot electron transistor or a resonant-tunnelling bipolar transistor (RBT).

According to a second aspect of the present invention, there is provided latching circuitry comprising three logic gates, each according to the first aspect of the present invention, the output terminal of each gate being connected to the input terminal of another of the gates such that the gates form a closed loop; said latching circuitry thereby being operable, when a pulse signal which is substantially equal to said first working voltage value, said second working voltage value, or said third working voltage value is applied to the input terminal of one of the said resonant-tunnelling transistors of said logic gates, to latch one of the output terminals of said logic gates at one of said first, second or third output values, another of the output terminals of said logic gates at another of said first, second or third output values, and the other of the output terminals of said logic gates at the other of the said first, second or third output values, in dependence upon the value of said pulse signal.

According to a third aspect of the present invention, there is provided a semiconductor memory device comprising a plurality of word lines, a plurality of bit lines, and a plurality of memory calls connected between respective word lines and bit lines, each memory cell comprising latching circuitry in accordance with the second aspect of the present invention and a first transfer gate, which first transfer gate is arranged and connected to transfer data, provided at an output terminal of one of the logic gates forming said latching circuitry, to a bit line associated with the memory cell concerned in response to a control signal delivered to the said first transfer gate via a word line associated with the memory cell concerned, the device further comprising a data bus line and a plurality of second transfer gates, which second transfer gates are associated with respective bit lines and are each arranged and connected to transfer data from the bit line associated therewith to the said data bus line in response to a further control signal.

Reference will now be made, by way of example, to the accompanying drawings, in which:

Figs. 1a and 1b show views representing a structure and an energy state of a resonant-tunnelling hot electron transistor (RHET);

Fig. 1c shows a view representing an energy state of a resonant-tunnelling bipolar transistor (RBT);

Figs. 2a to 2c are graphs illustrating an energy state of the resonant-tunnelling transistor in Fig. 1a;

Fig. 3 is a graph of the characteristics of the resonant-tunnelling transistor in Fig. 1a;

Fig. 4 is a circuit diagram of a logic gate embodying the first aspect of the present invention;

Fig. 5 is a graph for use in explaining the operation of the logic gate in Fig. 4;

Figs. 6a and 6b show views of latching circuitry embodying the second aspect of the present invention, Fig. 6b being a simplified circuit diagram thereof, and Fig. 6c is a truth table of that latching circuitry;

Fig. 7 is a circuit diagram of a semiconductor memory device embodying the third aspect of the present invention;

Fig. 8 is a graph for use in explaining the operation of the semiconductor memory device of Fig. 7; and

Figs. 9 and 10 show views of modifications of the device of Fig. 7.

Before describing the preferred embodiments of the present invention, a description will be given of the principle of a resonant-tunneling transistor device.

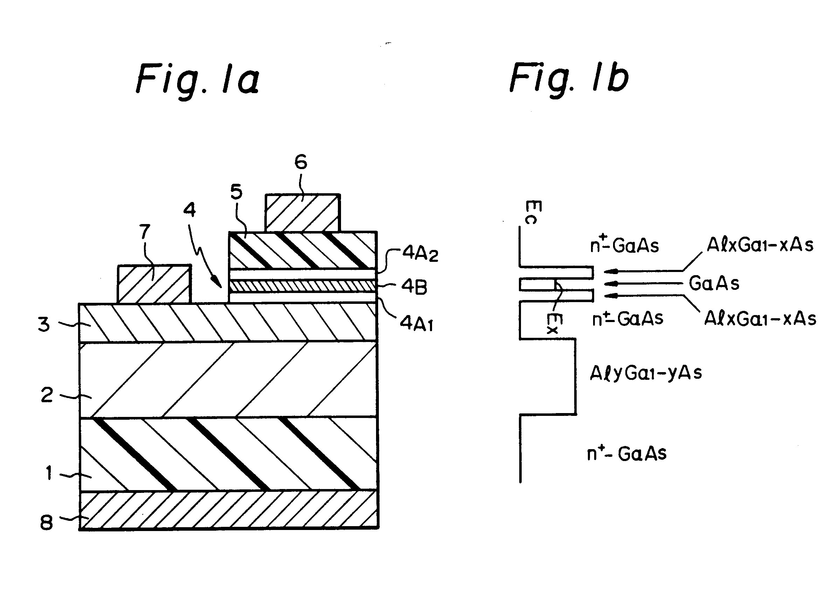

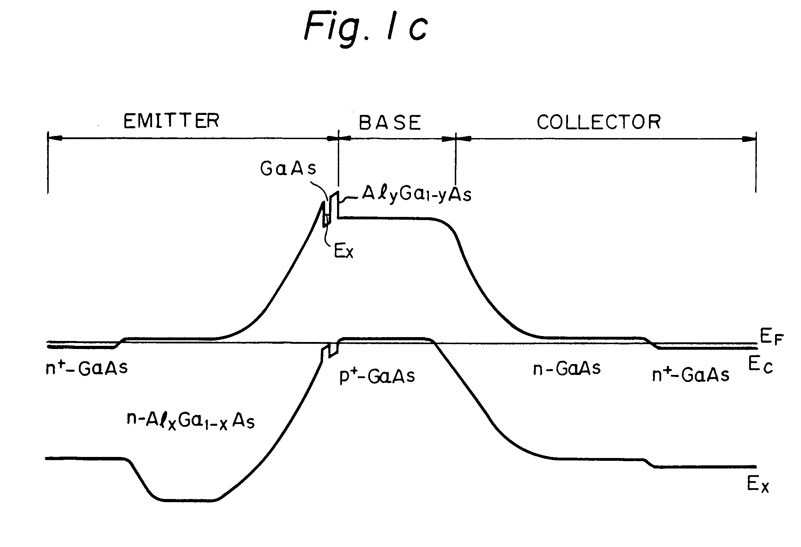

Figure 1a is a sectional view of a semifinished RHET device, and Fig. 1b is a graph of an energy band of the RHET device in Fig. 1a. In Fig. 1a, the resonant-tunneling transistor device consists of a collector electrode 8, an $n^+$ - type GaAs collector layer 1, formed on the collector electrode 8, a non-doped impurity $Al_yGa_{1-y}As$ (e.g. y = 0.3) collector side potential barrier layer 2 on the collector layer 1, an $n^+$ - type GaAs base layer 3, on the potential barrier layer 2, a superlattice structure 4, an $n^+$ - type GaAs emitter layer 5, an emitter electrode 6, and a base electrode 7. The superlattice structure 4 consists of an $Al_xGa_{1-x}As$ barrier layer $4A_1$, a non-doped impurity GaAs quantum well layer 4B, and an $Al_xGa_{1-x}As$ barrier layer $4A_2$. The superlattice structure 4 functions as an emitter side potential barrier. In this specification, the superlattice is defined such that at least one quantum well is provided therein. In Fig. 1a, a plurality of quantum wells may be formed.

In Fig. 1b, reference $E_C$ represents a bottom of a conduction-energy band, and $E_X$ an energy level of a sub-band (resonant-state energy level) at the quantum well.

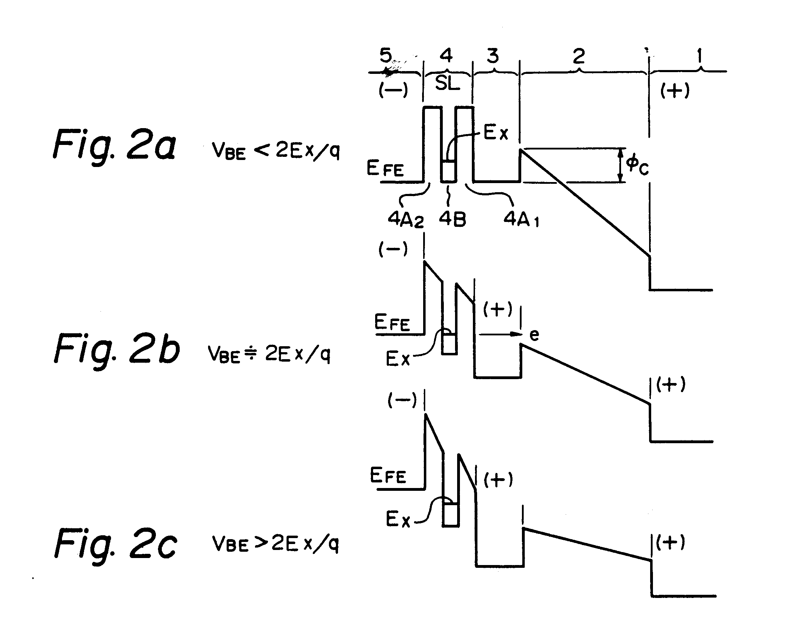

Referring to Figs. 2a to 2c, the principle of operation of the resonant-tunneling transistor device will be described.

Figure 2a is a graph of an energy band of the RHET device when a voltage $V_{BE}$ between the base layer 3 and the emitter layer 5 is lower than $2 \cdot E_X/q$, wherein q represents charge of carriers, or is too low, for example, approximately zero volt. In Fig. 2a, although a voltage $V_{CE}$ exists between the collector layer 1 and the emitter layer 5, electrons at the emitter layer 5 cannot reach the base layer 3 by tunneling through the superlattice layer 4, since the base emitter voltage $V_{BE}$ is almost zero, and thus a level of an energy $E_{FE}$, namely a quasi -Fermi level, of the emitter layer 5 differs from the energy level $E_X$ at the sub-band. Accordingly, a current does not flow between the emitter layer 5 and the collector layer 1. Reference $\phi_C$ represents a conduction-band discontinuity.

Figure 2b is a graph of an energy band of the RHET device when the base emitter voltage $V_{BE}$ is approximately equal to $2 \cdot E_X/q$. In Fig 2b, the energy level $E_{FE}$ at the emitter layer 5 is substantially equal to the energy level $E_X$ of the sub-band at the quantum well layer 4B. As a result, due to a resonant-tunneling effect, elections at the emitter layer 5 are passed through the superlattice layer 4 and injected into the base layer 3. The potential energy of the injected electrons, for example, 0.3 eV, is converted into kinetic energy, bringing the electrons to a so-called "hot" state. The hot electrons are ballistically passed through the base layer 3 and reach the collector layer 1. As a result, a current flows between the emitter layer 5 and the collector layer 1.

Fig. 2c is a graph of an energy band of the RHET device when the base emitter voltage $V_{BE}$ is higher than the $2 \cdot E_X/q$. In Fig. 2c, the energy level $E_{FE}$ at the emitter layer 5 is higher than the energy level $E_X$ of the sub-band at the quantum well layer 4B. In the known transistor, the resonant-tunnelling effect does not occur in these circumstances, and the electrons introduced from the emitter layer 5 to the base layer 3 do not exist, with a consequent drop in current flowing in the RHET device. In contrast, a logic gate embodying the first aspect of the present invention employs a resonant-tunnelling transistor in which, by decreasing the barrier height of the barrier layer $4A_1$ adjacent to the base layer 3 sufficiently, the electrons need only tunnel through the barrier layer $4A_2$ adjacent to the emitter layer 5. As a result, the collector current for $V_{BE}$ > $2E_x/q$ is enhanced.

Fig. 1c is a graph representing an energy band of a resonant-tunnelling bipolar transistor (RBT). A RBT consists of an emitter layer of $n^+$-type GaAs, a base layer of $p^+$-type GaAs, and a collector layer of $n^+$-type GaAs. The emitter layer includes a superlattice having at least one quantum well with a sub-band energy $E_x$. There is a PN junction at the interface between the base layer and the collector layer. Since the operation of a RBT also relies on resonant-tunnelling and is similar to that of the RHET, an explanation thereof is omitted.

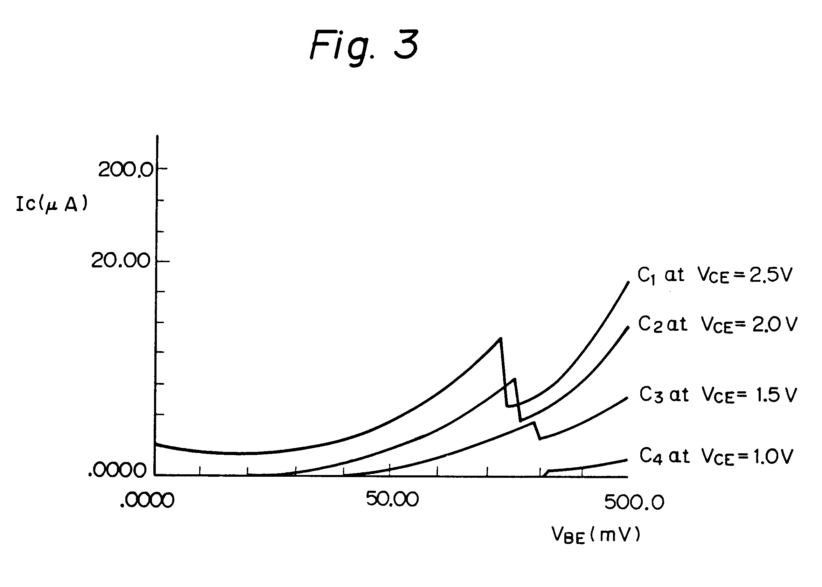

Fig. 3 is a graph representing the characteristics of the RHET device set forth above. In Fig. 3, the abscissa indicates the base-emitter voltage $V_{BE}$ and the ordinate indicates the collector current $I_C$. Curves $C_1$ to $C_4$ represent the characteristics when the collector-emitter voltage $V_{CE}$ is respectively 2.5 V, 2,0 V, 1.5 V, and 1.0 V, each of which curves indicates n-shaped differential negative-resistance characteristics.

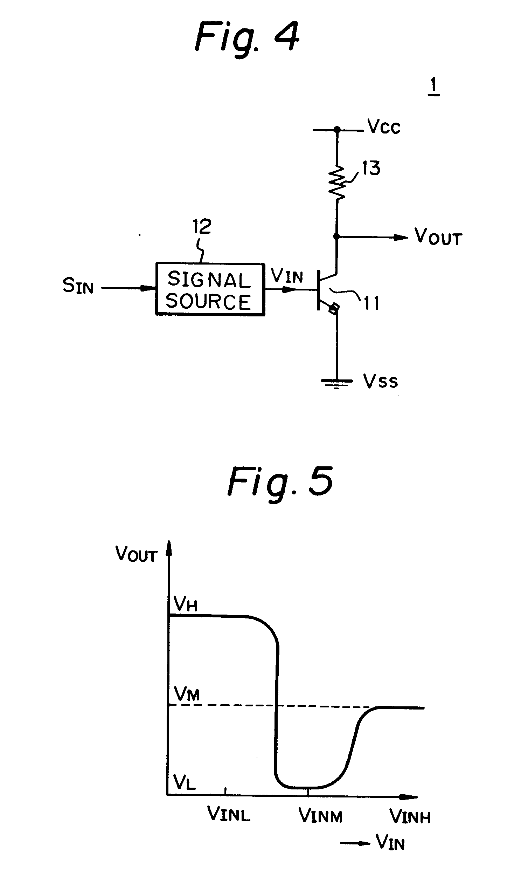

Referring to Figs. 4 and 5, a ternary logic gate 1 embodying the first aspect of the present invention and the operation thereof will be described.

The logic gate 1 includes a RHET 11, a signal source 12 supplying an input voltage $V_{IN}$, i.e. base-emitter voltage $V_{BE}$, to a base of the RHET 11, and a resistor 13 connected to the collector of the resonant-tunnelling transistor 11. An emitter of the RHET 11 is grounded ($V_{SS}$). Another end of the resistor 13 is connected to a DC power supply having a voltage $V_{CC}$. The signal source 12 outputs the voltage $V_{IN}$ having a working voltage value either of $V_{INH}$ which is higher than $2 \cdot E_x/q$ or $V_{INM}$ which is approximately equal to $2 \cdot E_x/q$, or $V_{INL}$ which is lower than $2 \cdot E_x/q$.

When the voltage $V_{IN}$ having a low value $V_{INL}$ is supplied to the base of the RHET 11, an output voltage $V_{OUT}$ at the collector of the RHET 11 is a high level $V_H$; when the median voltage $V_{INM}$ is supplied to the base of the RHET, the output voltage $V_{OUT}$ is low level $V_L$; and, when the high voltage $V_{INH}$ is supplied to the base of the RHET, the output voltage $V_{OUT}$ is median level $V_M$. The truth table of the ternary logic circuit in Fig. 4 as is follows;

Table 1

| $V_{IN}$ | $V_{OUT}$ |
|---|---|
| Low | High |
| Median | Low |
| High | Median |

Referring back to Fig. 3, preferably the local minimum value of the collector current $I_C$, i.e. when the input voltage is $V_{INH}$, is arranged to be a half of the local maximum value of the collector current, i.e. when the input voltage is $V_{INM}$.

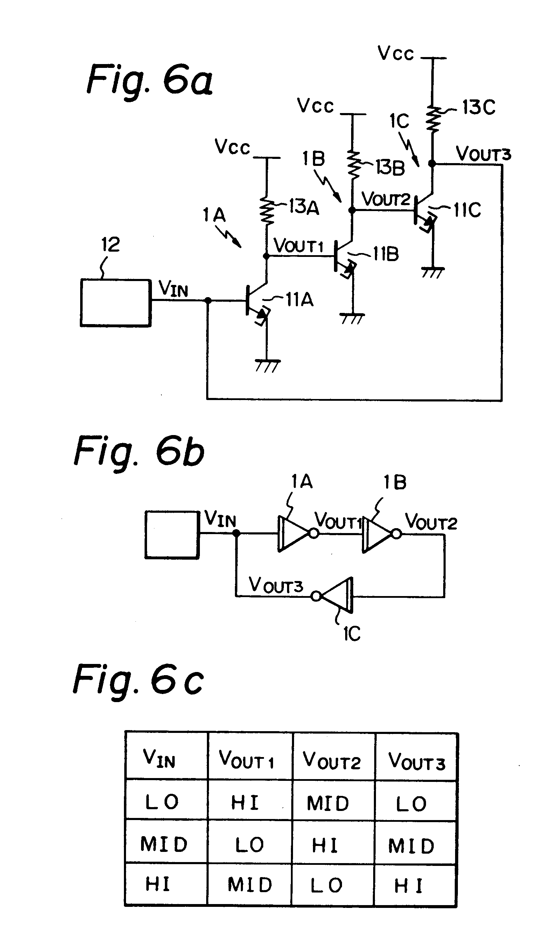

Fig. 6a shows a latch circuit which embodies the second aspect of the present invention and includes three logic gates 1A, 1B, 1C, as described above, i.e. three series and circular-connected RHETS 11A, 11B and 11C, and three resistors 13A, 13B, and 13C. The signal source 12 is connected to the RHET 11A. Fig. 6b is a simplified version of the circuit in Fig. 6a.

When the voltage $V_{IN}$ having the low level $V_{INL}$ ($V_{INL}$ = 0) is supplied to the RHET 11A, voltages $V_{OUT1}$ having a high level, $V_{OUT2}$ having a middle level and $V_{OUT3}$ having a low level are respectively output as shown in Fig. 6c. If the voltage $V_{IN}$ is changed to median level, a low level voltage $V_{OUT1}$, high level voltage $V_{OUT2}$ and median level voltage $V_{OUT3}$ are output. When the voltage $V_{IN}$ is high level, the voltages $V_{OUT1}$, $V_{OUT2}$, and $V_{OUT3}$ are median, low and high level, respectively. If the voltage $V_{IN}$ is changed to zero volt, the above voltage status is not changed. Thus, if a pulse voltage having an amplitude of $V_{INL}$, $V_{INM}$ or $V_{INH}$ is supplied to the resonant-tunneling transistor 11A, the RHETs 11A to 11C hold one of the conditions shown in Fig. 6c in response to the amplitude of the pulse voltage. As can be easily seen, the circuit in Fig. 6a functions as a tristable latch circuit.

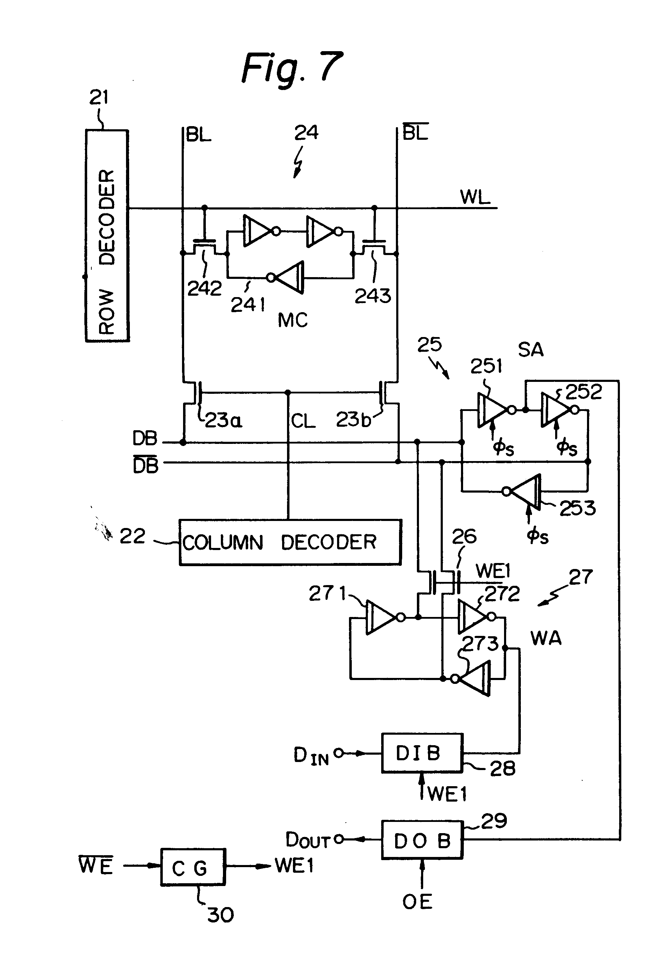

Fig. 7 is a partial circuit diagram of a semiconductor memory device which embodies the third aspect of the present invention and includes a row decoder 21 connected to a word line WL, a column decoder 22 activating column gate transistors 23a and 23b connected between bit lines BL, $\overline{BL}$ and data buses DB, $\overline{DB}$, and a memory cell 24 connected between the word line WL and the bit line BL, and between the word line WL and the bit line $\overline{BL}$. The memory cell 24 consists of a latch circuit 241, as shown in Figs. 6a and 6b, and transfer gates 242 and 243. The memory device also includes a sense amplifier 25 having three RHET's 251 to 253, a write amplifier 27 having three RHET's 271 to 273, and a pair of gate transistors 26 between the data buses DB and $\overline{DB}$ and the write amplifier 27. The memory device further includes a data input buffer 28, a data output buffer 29, and a clock generator 30.

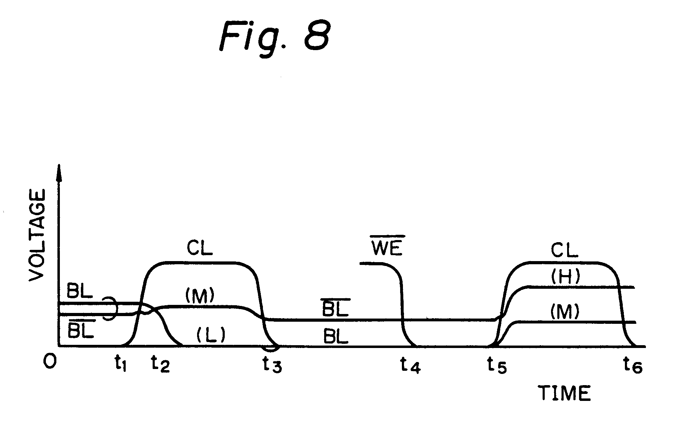

Referring to Fig. 8, the operation of the memory device will be described. In Fig. 8, the abscissa represents time, and the ordinate represents signal voltage. References H, M, and L represent high level, middle level, and low level voltages of the resonant-tunneling transistor.

First, the read operation will be described. The read operation is carried out during times 0 to $t_1$. Figure 8 represents a condition where the read operation was carried out for a memory cell (not shown) and the voltage equalization between the bit lines BL and $\overline{BL}$ was not fully completed, and therefore, a small voltage difference between the bit lines BL and $\overline{BL}$ still remains.

Upon receipt of an address signal, from an address buffer (not shown) that has received the address signal, the row decoder 21 and the column decoder 22, the word line WL, and the column gate transistors 23a and 23b are selected, as shown in Fig. 8. At a time $t_1$, a column gate signal CL is raised to turn ON the column gate transistors 23a and 23b. The gates 242 and 243 are also turned ON. Voltages from the latch circuit 241 are transferred on the bit lines BL and $\overline{BL}$. The voltages on the bit lines BL and $\overline{BL}$ are high level, middle level, or low level. The voltages are further transferred to the sense amplifier 25 through the column gate transistors 23a and 23b and the data buses DB and $\overline{DB}$. At the time $t_2$, upon receipt of a sense strobe signal $\phi s$, the sense amplifier 25 having a tristable flip-flop arrangement is activated to amplify the differential received voltage at a predetermined level. An output voltage amplified at the sense amplifier 25 is translated into a signal having a low impedance at the data output buffer 29, and output as an out data $D_{OUT}$ to an outside of a chip of the memory device by applying an output enable signal OE. The data output buffer 29 is a quad-state buffer having a fourth high impedance (Hi-Z) state in addition to the three high, median, and low states of the conventional tristate buffer.

Next, the write operation will be described. Upon receipt of an external inverted write enable signal $\overline{WE}$ at the clock generator 30 at a time $t_4$, the column gate transistors 23a and 23b are turned ON at a time $t_5$. An input data $O_{IN}$ is supplied to the write amplifier 27 having a tristable flip flop arrangement through the data input buffer 28 in response to an internal write enable signal WE1. The sense amplifier 27 has a larger drive capacity than the sense amplifier 25, but has a similar circuit construction. The amplified input data is transferred to the memory cell 24 through the gate transistors 26, the data buses DB and $\overline{DB}$, the column gate transistors 23a and 23b, and the bit lines BL and $\overline{BL}$. The input data is stored in the latch circuit 241 through the transfer gates 242 and 243. The content in the latch circuit 241 is one of three states.

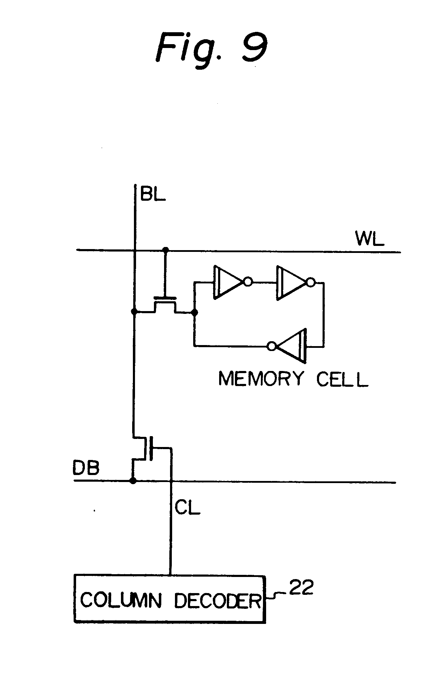

Referring to Fig. 9, modified sense amplifier, emboding the third aspect of the present invention, is shown, which employs a single bit line BL and a single data bus DB. This circuit increases the integration of IC devices but has a lower operation speed.

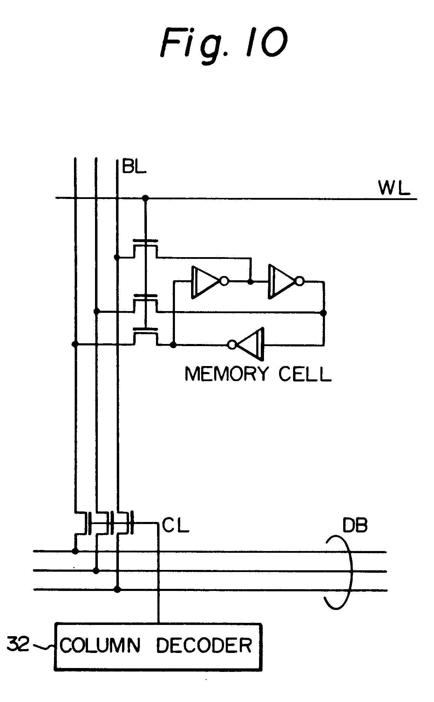

Referring to Fig. 10, another modified sense amplifier, embodying the third aspect of the present invention, is shown, which employs three bits lines BL and three data buses DB. This circuit improves the operation speed, but has a lower integration.

In the above embodiment, the tristate data input and output circuits are used. These can be changed by a tristate-to-bistate conversion circuit to adapt to the conventional binary circuit. The conversion circuit is provided in a chip. The ternary signal processing is effected in the chip, and the conventional binary signal processing is effected outside of the chip. This circuit construction has a disadvantage in that a conversion time is required at the conversion circuit. The capacity of the memory is only 1.5 times that of the binary, for example, a 64K cell array corresponds to a 96K cell array. That is, the advantage of a $2^n$ memory capacity cannot be obtained, and the memory addressing would be complex. Although it is inconvenient to provide the conversion circuit, an error checking and correction (ECC) circuit may be formed preferably, because, for example, 64K cells substantially function as 96K cells.

## Claims

1. A logic gate (1) comprising:

a resonant-tunnelling transistor (11) having a base (3), an emitter (5) and a collector (1), there being between the base (3) and the emitter (5) a superlattice structure (4) providing a quantum well layer (4B) between first and second barrier layers ($4A_1$, $4A_2$), said quantum well layer (4B) having a resonant-state energy level ($E_x$); and

a resistor (13) connected in series, between first and second power supply lines ($V_{cc}$, $V_{ss}$), with the emitter-collector current path of said resonant-tunnelling transistor (11);

the base (3) of said resonant-tunnelling transistor (11) serving as an input terminal of the logic gate (1) for the application thereto of an input voltage signal ($V_{IN}$) constituting a base-to-emitter voltage of the said transistor when the gate is in use; and

a circuit node between the said resistor (13) and the transistor (11) serving as an output terminal of the logic gate (1) for delivering an output voltage signal ($V_{OUT}$) when the gate is in use;

whereby when the input voltage signal ($V_{IN}$) is increased, from a first working voltage value to a second working voltage value, current passing along the said emitter-collector current path is thereby caused to increase from a first current value to a second current value, and when the input voltage signal ($V_{IN}$) is increased from the second working voltage value to a third working voltage value such current is thereby caused to decrease from said second current value to a third current value;

the said superlattice structure (4) being so formed that when the said input voltage signal ($V_{IN}$) has the said third working voltage value the potential height of one of said first and second barrier layers ($4A_1$, $4A_2$) differs from that of the other sufficiently to ensure that said third current value lies between and is distinct from the said first and second current values, so that the said output voltage signal ($V_{OUT}$) has discrete first, second and third output values respectively when the said input voltage signal ($V_{IN}$) has the said first, second and third working voltage values, the said third output value of the output voltage signal ($V_{OUT}$) being between the said first and second output values thereof.

2. A logic gate as claimed in claim 1, wherein the said third current value is approximately half the said second current value.

3. A logic gate as claimed in claim 1 or 2, wherein said second working voltage value is approximately equal to $2E_x/q$, where $E_x$ is the resonant-state energy level, and q represents the charge on carriers in the said resonant-tunnelling transistor (11).

4. Latching circuitry comprising three logic gates (1A, 1B, 1C), each gate being a logic gate as claimed in any preceding claim, the output terminal of each gate (1A, 1B, 1C) being connected to the input terminal of another of the gates such that the gates form a closed loop;

said latching circuitry thereby being operable, when a pulse signal which is substantially equal to said first working voltage value, said second working voltage value, or said third working voltage value is applied to the input terminal of one of the said resonant-tunnelling transistors (11A, 11B, 11C) of said logic gates (1A, 1B, 1C), to latch one of the output terminals of said logic gates (1A, 1B, 1C) at one of said first, second or third output values, another of the output terminals of said logic gates (1A, 1B, 1C) at another of said first, second or third output values, and the other of the output terminals of said logic gates (1A, 1B, 1C) at the other of the said first, second or third output values, in dependence upon the value of said pulse signal.

5. A semiconductor memory device comprising a plurality of word lines (WL), a plurality of bit lines (BL, $\overline{BL}$), and a plurality of memory cells (MC) connected between respective word lines (WL) and bit lines (BL, $\overline{BL}$) each memory cell (MC) comprising latching circuitry (241) as claimed in claim 4 and a first transfer gate (242, 243), which first transfer gate (242, 243) is arranged and connected to transfer data, provided at an output terminal of one of the logic gates forming said latching circuitry (241), to a bit line (BL, $\overline{BL}$) associated with the memory cell (MC) concerned in response to a control signal delivered to the said first transfer gate (242, 243) via a word line (WL) associated with the memory cell (MC) concerned, the device further comprising a data bus line (DB, $\overline{DB}$) and a plurality of second transfer gates (23a, 23b), which second transfer gates (23a, 23b) are associated with respective bit lines (BL, $\overline{BL}$) and are each arranged and connected to transfer data from the bit line (BL, $\overline{BL}$) associated therewith to the said data bus line (DB, $\overline{DB}$) in response to a further control signal.

6. A device as claimed in claim 5, wherein each memory cell (MC) has an additional first transfer gate (242, 243) which is arranged and connected to transfer data, provided at an output terminal of another of the logic gates forming said latching circuitry (241), to a further bit line (BL, $\overline{BL}$) of said plurality of bit lines which is associated with the memory cell (MC) concerned, in response to said control signal which is delivered to the additional first transfer gate via the word line (WL) associated with the memory cell (MC) concerned, and wherein the device further comprises an additional data bus line (DB, $\overline{DB}$) and a further plurality of second transfer gates (23a, 23b), which second transfer gates of said further plurality are associated with respective further bit lines (BL, $\overline{BL}$) and are each arranged and connected to transfer data from the further bit line (BL, $\overline{BL}$) associated therewith to the said additional data bus line (DB, $\overline{DB}$) in response to said further control signal.

## EP 0 220 020 B1

7. A device as claimed in claim 6, further comprising a sense amplifier (SA) including latching circuitry as claimed in claim 4, the said data bus line (DB, $\overline{DB}$) and the said additional data bus line (DB, $\overline{DB}$) being connected respectively to transfer data to two of the three output terminals of the logic gates forming the latching circuitry (241) of said sense amplifier (SA).

8. A device as claimed in claim 6 or 7, further comprising a write amplifier (WA) including latching circuitry (241) as claimed in claim 4, the said data bus line (DB, $\overline{DB}$) and the said additional data bus line (DB, $\overline{DB}$) being connected respectively to transfer data to two of the three output terminals of the logic gates forming the latching circuitry (241) of said write amplifier (WA).

## Revendications

1. Porte logique (1) comprenant:
   un transistor résonnant par effet tunnel (11) comportant une base (3), un émetteur (5) et un collecteur (1), une structure de superréseau (4) se trouvant entre la base (3) et l'émetteur (5) fournissant une couche à trou d'énergie (4B) entre des première et seconde couches d'arrêt ($4A_1$, $4A_2$), ladite couche à trou d'énergie (4B) ayant un niveau d'énergie d'état de résonance ($E_x$); et
   une résistance (13) connectée en série, entre des premier et second fils de tension d'alimentation ($V_{cc}$, $V_{ss}$), avec la voie de courant émetteur-collecteur dudit transistor résonnant par effet tunnel (11);
   la base (3) dudit transistor résonnant par effet tunnel (11) servant de borne d'entrée de la porte logique (1) pour l'application à celle-ci d'un signal de tension d'entrée ($V_{IN}$) constituant une tension de base à émetteur dudit transistor quand la porte est en fonctionnement; et
   un noeud de circuit entre ladite résistance (13) et le transistor (11) servant de borne de sortie de la porte logique (1) pour fournir un signal de tension de sortie ($V_{OUT}$) quand la porte est en fonctionnement;
   par laquelle, quand le signal de tension d'entrée ($V_{IN}$) est augmenté, d'une première valeur de tension active à une deuxième valeur de tension active, le courant passant le long de ladite voie de courant émetteur-collecteur est ainsi amené à augmenter d'une première valeur de courant à une deuxième valeur de courant, et, quand le signal de tension d'entrée ($V_{IN}$) est augmenté de la deuxième valeur de tension active à une troisième valeur de tension active, ce courant est ainsi amené à diminuer de ladite deuxième valeur de courant à une troisième valeur de courant;
   ladite structure de superréseau (4) étant formée de telle sorte que, lorsque ledit signal de tension d'entrée ($V_{IN}$) a ladite troisième valeur de tension active, la hauteur de potentiel d'une desdites première et seconde couches d'arrêt ($4A_1$,$4A_2$) diffère de celle de l'autre suffisamment pour garantir que ladite troisième valeur de courant se trouve entre lesdites et est distincte desdites première et deuxième valeurs de courant, de telle sorte que ledit signal de tension de sortie ($V_{OUT}$) a respectivement des première, deuxième et troisième valeurs de sortie discrètes quand ledit signal de tension d'entrée ($V_{IN}$) a lesdites première, deuxième et troisième valeurs de tension active, ladite troisième valeur de sortie du signal de tension de sortie ($V_{OUT}$) étant comprise entre lesdites première et deuxième valeurs de sortie de celui-ci.

2. Porte logique selon la revendication 1, dans laquelle ladite troisième valeur de courant est approximativement égale à la moitié de ladite deuxième valeur de courant.

3. Porte logique selon l'une quelconque des revendication 1 et 2, dans laquelle ladite deuxième valeur de tension active est approximativement égale à $2E_X/q$, où $E_X$ est le niveau d'énergie d'état de résonance, et q représente la charge des porteurs dans ledit transistor résonnant par effet tunnel (11).

4. Circuits de verrouillage comprenant trois portes logiques (1A,1B,1C), chaque porte étant une porte logique selon l'une quelconque des revendications 1 à 3, la borne de sortie de chaque porte (1A,1B,1C) étant connectée à la borne d'entrée d'une autre des portes de telle sorte que les portes forment une boucle fermée;
   lesdits circuits de verrouillage pouvant être mis en fonctionnement par celles-ci, quand un signal pulsé qui est effectivement égal à ladite première valeur de tension active, à ladite deuxième valeur de tension active, ou à ladite troisième valeur de tension active est appliqué à la borne d'entrée d'un desdits transistors résonnant par effet tunnel (11A,11B,11C) desdites portes logiques (1A,1B,1C), pour bloquer une des bornes de sortie desdites portes logiques (1A,1B,1C) à une desdites première, deuxième et troisième valeurs de sortie, une autre des bornes de sortie desdites portes logiques (1A,1B,1C) à une autre desdites première, deuxième et troisième valeurs de sortie, et l'autre des bornes de sortie desdites portes logiques (1A,1B,1C) à l'autre desdites première, deuxième et troisième valeurs, de sortie selon la valeur dudit signal pulsé.

5. Dispositif de mémoire à semiconducteur comprenant une pluralité de fils de mot (WL),une pluralité de fils de bit (BL,$\overline{BL}$), et une pluralité de cellules de mémoire (MC) connectées entre des fils de mot (WL) et des fils de bit (BL,$\overline{BL}$) respectifs, chaque cellule de mémoire (MC) comprenant des circuits de verrouillage (241) tels que revendiqués dans la revendication 4 et une première porte de transfert (242,243), cette première porte de transfert (242,243) étant agencée et connectée pour transférer des données, fournies à une borne de sortie d'une des portes logiques constituant lesdits circuits de verrouillage (241), jusqu'à un fil de bit (BL,$\overline{BL}$) associé à la cellule de mémoire (MC) concernée en réponse à un signal de commande fourni à ladite première porte de transfert (242,243) par l'intermédiaire d'un fil de mot (WL) associé à la cellule de mémoire (MC) concernée, le dispositif comprenant en outre un fil de bus de données (DB,$\overline{DB}$) et une pluralité de secondes portes de transfert (23a,23b), ces secondes portes de transfert (23a,23b) étant associées à des fils de bit respectifs (BL,$\overline{BL}$) et étant chacune agencées et connectées pour transférer des données du fil de bit (BL,$\overline{BL}$) associé à celle -ci jusqu'audit fil de bus de données (DB,$\overline{DB}$) en réponse à un autre signal de commande.

6. Dispositif selon la revendication 5, dans lequel chaque cellule de mémoire (MC) comporte une première porte de transfert supplémentaire (242,243) qui est agencée et connectée pour transférer des données, fournies à une borne de sortie d'une autre des portes logiques constituant lesdits circuits de verrouillage (241), jusqu'à un autre fil de bit (BL,$\overline{BL}$) de ladite pluralité des fils de bit qui est associé à la cellule de mémoire (MC) concernée, en réponse audit signal de commande qui est fourni à la première porte de transfert supplémentaire par l'intermédiaire du fil de mot (WL) associé à la cellule de mémoire (MC) concernée, et dans lequel ce dispositif comprend en outre un fil de bus de données supplémentaire (DB,$\overline{DB}$) et une autre pluralité de secondes portes de transfert (23a,23b), ces secondes portes de transfert de ladite autre pluralité étant associées à des autres fils de bit respectifs (BL,$\overline{BL}$) et étant chacune agencées et connectées pour transférer des données dudit autre fil de bit (BL,$\overline{BL}$) associé à celle -ci jusqu'audit fil de bus de données supplémentaire (DB,$\overline{DB}$) en réponse audit autre signal de

7. Dispositif selon la revendication 6, comprenant en outre un amplificateur de détection (SA) incluant des circuits de verrouillage selon la revendication 4, ledit fil de bus de données (DB,$\overline{DB}$) et ledit fil de bus de données supplémentaire (DB,$\overline{DB}$) étant respectivement connectés pour transférer des données jusqu'à deux des trois bornes de sortie des portes logiques constituant les circuits de verrouillage (241) dudit amplificateur de détection (SA).

8. Dispositif selon l'une quelconque des revendications 6 et 7, comprenant en outre un amplificateur d'écriture (WA) incluant des circuits de verrouillage (241) selon la revendication 4, ledit fil de bus de données (DB,$\overline{DB}$) et ledit fil de bus de données supplémentaire (DB,$\overline{DB}$) étant respectivement connectés pour transférer des données jusqu'à deux des trois bornes de sortie des portes logiques constituant les circuits de verrouillage (241) dudit amplificateur d'écriture (WA).

**Patentansprüche**

1. Ein logisches Gatter (1) mit:
   einem Resonanz-Tunneltransistor (11) mit einer Basis (3), einem Emitter (5) und einem Kollektor (1), wobei sich zwischen der Basis (3) und dem Emitter (5) eine Überstruktur (4) befindet, welche zwischen einer ersten und zweiten Sperrschicht (4A$_1$, 4A$_2$) eine Quantengrabenschicht (4B) bildet, welche genannte Quantengrabenschicht (4B) ein Resonanzzustandsenergieniveau (E$_x$) hat; und
   einem Widerstand (13), der zwischen der ersten und zweiten Stromversorgungsleitung (V$_{CC}$, V$_{SS}$) mit dem Emitter-Kollektor-Strompfad des genannten Resonanz-Tunneltransistors (11) in Reihe geschaltet ist;
   wobei die Basis (3) des genannten Resonanz-Tunneltransistors (11) als Eingangsklemme des logischen Gatters (1) für das Anlegen eines Eingangsspannungssignals (V$_{IN}$) dient, welches eine Basis-Emitter-Spannung des genannten Transistors bildet, wenn das Gatter in Betrieb ist;
   und wobei ein Schaltungsknoten zwischen dem genannten Widerstand (13) und dem Transistor (11) als Ausgangsklemme des logischen Gatters (1) für die Lieferung eines Ausgangsspannungssignals

($V_{OUT}$) dient, wenn das Gatter in Betrieb ist;

wodurch, wenn das Eingangsspannungssignal ($V_{IN}$) von einem ersten Arbeitsspannungswert auf einen zweiten Arbeitsspannungswert erhöht wird, dadurch veranlaßt wird, daß sich der dem genannten Emitter-Kollektor-Strompfad entlangfließende Strom von einem ersten Stromwert auf einen zweiten Stromwert erhöht, und wenn das Eingangsspannungssignal ($V_{IN}$) von dem zweiten Arbeitsspannungswert auf einen dritten Arbeitsspannungswert erhöht wird, dadurch veranlaßt wird, daß sich dieser Strom von dem genannten zweiten Stromwert auf einen dritten Stromwert erniedrigt;

wobei die genannte Überstruktur (4) so gebildet ist, daß, wenn das genannte Eingangsspannungssignal ($V_{IN}$) den genannten dritten Arbeitsspannungswert hat, die Potentialhöhe einer der genannten ersten und zweiten Sperrschichten ($4A_1$, $4A_2$) von der der anderen ausreichend abweicht, um sicherzustellen, daß der genannte dritte Stromwert dazwischen liegt und sich von dem ersten und zweiten Stromwert unterscheidet, so daß das genannte Ausgangsspannungssignal ($V_{OUT}$) diskrete erste, zweite bzw. dritte Ausgangswerte hat, wenn das genannte Eingangsspannungssignal ($V_{IN}$) die genannten ersten, zweiten und dritten Arbeitsspannungswerte hat, wobei der genannte dritte Ausgangswert des Ausgangsspannungssignals ($V_{OUT}$) zwischen dessen genannten ersten und zweiten Werten liegt.

2. Ein logisches Gatter nach Anspruch 1, bei welchem der genannte dritte Stromwert etwa halb so groß wie der genannte zweite Stromwert ist.

3. Ein logisches Gatter nach Anspruch 1 oder 2, bei welchem der genannte zweite Arbeitsspannungswert etwa gleich $2E_x/q$ ist, wobei $E_x$ das Resonanzzustandsenergieniveau ist und q die Ladung auf Trägern in dem genannten Resonanz-Tunneltransistor (11) darstellt.

4. Eine Verriegelungsschaltung mit drei logischen Gattern (1A, 1B, 1C), wobei jedes Gatter ein logisches Gatter nach irgendeinem vorhergehenden Anspruch ist, wobei die Ausgangsklemme jedes Gatters (1A, 1B, 1C) mit der Eingangsklemme eines anderen der Gatter verbunden ist, so daß die Gatter eine geschlossene Schleife bilden;

wobei die genannte Verriegelungsschaltung dadurch betriebsfähig ist, wenn ein Impulssignal, welches im wesentlichen gleich dem genannten ersten Arbeitsspannungswert, dem genannten zweiten Arbeitsspannungswert oder dem genannten dritten Arbeitsspannungswert ist, an die Eingangsklemme eines der genannten Resonanz-Tunneltransistoren (11A, 11B, 11C) der genannten logischen Gatter (1A, 1B, 1C) angelegt ist, um eine der Ausgangsklemmen der genannten logischen Gatter (1A, 1B, 1C) auf einem der genannten ersten, zweiten oder dritten Ausgangswerte, eine andere der Ausgangsklemmen der genannten logischen Gatter (1A, 1B, 1C) auf einem anderen der genannten ersten, zweiten oder dritten Ausgangswerte, und die andere der Ausgangsklemmen der genannten logischen Gatter (1A, 1B, 1C) auf dem anderen der genannten ersten, zweiten oder dritten Ausgangswerte zu verriegeln, in Abhängigkeit vom Wert des genannten Impulssignals.

5. Eine Halbleiterspeicheranordnung mit einer Vielzahl von Wortleitungen (WL), einer Vielzahl von Bitleitungen (BL, $\overline{BL}$) und einer Vielzahl von Speicherzellen (MC), die zwischen den entsprechenden Wortleitungen (WL) und Bitleitungen (BL, $\overline{BL}$) geschaltet sind, wobei jede Speicherzelle (MC) eine Verriegelungsschaltung (241) nach Anspruch 4 und ein erstes Übertragungsgatter (242, 243) umfaßt, welches erste Übertragungsgatter (242, 243) zum Übertragen von Daten, die an einer Ausgangsklemme eines der logischen Gatter, die die genannte Verriegelungsschaltung (241) bilden, zur Verfügung stehen, zu einer Bitleitung (BL, $\overline{BL}$) angeordnet und geschaltet ist, welche mit der betreffenden Speicherzelle (MC) verbunden ist, ansprechend auf ein Steuersignal, welches an das genannte erste Übertragungsgatter (242, 243) über eine Wortleitung (WL), die mit der betreffenden Speicherzelle (MC) verbunden ist, geliefert wird, wobei die Anordnung ferner eine Datenbusleitung (DB, $\overline{DB}$) und eine Vielzahl von zweiten Übertragungsgattern (23a, 23b) umfaßt, welche zweiten Übertragungsgatter (23a, 23b) mit entsprechenden Bitleitungen (BL, $\overline{BL}$) verbunden und jeweils zum Übertragen von Daten von der damit verbundenen Bitleitung (BL, $\overline{BL}$) zu der genannten Datenbusleitung (DB, $\overline{DB}$), ansprechend auf ein weiteres Steuersignal, angeordnet und geschaltet sind.

6. Eine Anordnung nach Anspruch 5, bei welcher jede Speicherzelle (MC) ein zusätzliches erstes Übertragungsgatter (242, 243) hat, welches zum Übertragen von Daten, die an einer Ausgangsklemme eines anderen der logischen Gatter, die die genannte Verriegelungsschaltung (241) bilden, zur Verfügung stehen, zu einer weiteren Bitleitung (BL, $\overline{BL}$) der genannten Vielzahl von Bitleitungen, welche mit der betreffenden Speicherzelle (MC) verbunden ist, angeordnet und geschaltet ist, ansprechend auf das genannte Steuersignal, welches an das zusätzliche erste Übertragungsgatter über die Wortleitung (WL), die mit der betreffenden Speicherzelle (MC) verbunden ist, geliefert wird, und bei welcher die Anordnung ferner eine zusätzliche Datenbusleitung (DB, $\overline{DB}$) und eine weitere Vielzahl von zweiten Übertragungsgattern (23a, 23b) umfaßt, welche zweiten Übertragungsgatter der genannten weiteren Vielzahl mit den entsprechenden weiteren Bitleitungen (BL, $\overline{BL}$) verbunden und jeweils zum Übertragen von Daten von der damit verbundenen weiteren Bitleitung (BL, $\overline{BL}$) zu der genannten zusätzlichen Datenbusleitung (DB, $\overline{DB}$), ansprechend auf das genannte weitere Steuersignal, angeordnet und geschaltet sind.

7.  Eine Anordnung nach Anspruch 6, welche ferner einen Leseverstärker (SA) umfaßt, der eine Verriegelungsschaltung nach Anspruch 4 enthält, wobei die genannte Datenbusleitung (DB, $\overline{DB}$) und die genannte zusätzliche Datenbusleitung (DB, $\overline{DB}$) jeweils zum Übertragen von Daten zu zwei der drei Ausgangsklemmen der logischen Gatter, die die Verriegelungsschaltung (241) des genannten Leseverstärkers (SA) bilden, geschaltet sind.

8.  Eine Anordnung nach Anspruch 6 oder 7, welche ferner einen Schreibverstärker (WA) umfaßt, der eine Verriegelungsschaltung (241) nach Anspruch 4 enthält, wobei die genannte Datenbusleitung (DB, $\overline{DB}$) und die genannte zusätzliche Datenbusleitung (DB, $\overline{DB}$) jeweils zum Übertragen von Daten zu zwei der drei Ausgangsklemmen der logischen Gatter, die die Verriegelungsschaltung (241) des genannten Schreibverstärkers (WA) bilden, geschaltet sind.

## Fig. Ia

7  4  5  6

4A₂
4B
4A₁

3
2
1
8

## Fig. Ib

Ec

n⁺-GaAs        AlxGa1-xAs
GaAs
Ex
n⁺-GaAs        AlxGa1-xAs

AlyGa1-yAs

n⁺- GaAs

EP 0 220 020 B1

# Fig. 1c

EP 0 220 020 B1

Fig. 2a  $V_{BE} < 2E_x/q$

Fig. 2b  $V_{BE} \doteqdot 2E_x/q$

Fig. 2c  $V_{BE} > 2E_x/q$

13

# Fig. 3

# Fig. 4

# Fig. 5

## Fig. 6a

## Fig. 6b

## Fig. 6c

| $V_{IN}$ | $V_{OUT1}$ | $V_{OUT2}$ | $V_{OUT3}$ |
|----------|------------|------------|------------|
| LO       | HI         | MID        | LO         |
| MID      | LO         | HI         | MID        |
| HI       | MID        | LO         | HI         |

# Fig. 7

Fig. 8

# Fig. 9

BL

WL

MEMORY CELL

DB

CL

COLUMN DECODER — 22

# Fig. 10

MEMORY CELL

BL WL CL DB

32 ~ COLUMN DECODER